# EUROPEAN PATENT APPLICATION

(11) **EP 4 727 313 A1**
(43) Date of publication of application: **15.04.2026**
(21) Application number: 24922476.7
(22) Date of filing: 12.12.2024
(51) Int. Cl.: H10K 59/122, H10K 59/35, H10K 59/80, H10K 59/38

(54) **DISPLAY DEVICE**

(30) Priority: 30.01.2024 KR 20240013912
(71) Applicant: Samsung Display Co., Ltd., Yongin-si, Gyeonggi-do 17113 (KR)
(72) Inventor: MIN, Kyoung Hae, Yongin-si Gyeonggi-do 17113 (KR); HWANG, Tae Hyung, Yongin-si Gyeonggi-do 17113 (KR); KIM, Jang Il, Yongin-si Gyeonggi-do 17113 (KR); KIM, Jeong Ki, Yongin-si Gyeonggi-do 17113 (KR); LEE, Seong Yeon, Yongin-si Gyeonggi-do 17113 (KR); HONG, Seok Joon, Yongin-si Gyeonggi-do 17113 (KR)
(74) Representative: Walaski, Jan Filip
(86) International application number: PCT/KR2024/096855
(87) International publication number: WO 2025/164968

(57) **Abstract**

A display device includes a substrate, where a first light emitting area, a second light emitting area, and a third light emitting area, which emit light in different wavelength bands, respectively, are defined on the substrate, a bank pattern disposed on the substrate and defining a first opening overlapping the first light emitting area, a second opening overlapping the second light emitting area, and a third opening overlapping the third light emitting area, and a liquid-repellent pattern filling the second opening and the third opening and disposed on at least a portion of an upper surface of the bank pattern, where the liquid-repellent pattern includes a liquid-repellent material.

## Description

### [Technical Field]

Embodiments relate to a display device. More specifically, embodiments relate to a display device that provides visual information.

### [Background Art]

A display device may include a light emitting layer and a color conversion layer to improve display quality. Light may be emitted from the light emitting layer, and the color conversion layer may convert a wavelength of the light emitted from the light emitting layer. Accordingly, the color conversion layer may emit light in a wavelength band different from that of the incident light.

The color conversion layer may include a wavelength conversion particle such as a quantum dot. For example, the color conversion layer may be divided into a red color conversion pattern, a green color conversion pattern, and a blue color conversion pattern (or a transmission pattern).

### [Disclosure]

### [Technical Problem]

One object of the present invention is to provide a display device with improved quality.

However, the purpose of the present invention is not limited to this purposes, and may be expanded in various ways without departing from the spirit and scope of the present invention.

### [Technical Solution]

In order to achieve one object of the present invention described above, a display device according to an embodiment of the invention may includes a substrate where a first light emitting area, a second light emitting area, and a third light emitting area which emit light in different wavelength bands, respectively, are defined on the substrate, a bank pattern disposed on the substrate and defining a first opening overlapping the first light emitting area, a second opening overlapping the second light emitting area, and a third opening overlapping the third light emitting area, and a liquid-repellent pattern filling the second opening and the third opening and disposed on at least a portion of an upper surface of the bank pattern, where the liquid-repellent pattern includes a liquid-repellent material.

In an embodiment, the liquid-repellent pattern may further include a scatterer.

In an embodiment, the display device may further include a reflective pattern disposed between the bank pattern and the liquid-repellent pattern.

In an embodiment, the reflective pattern may cover the upper surface and a side surface of the bank pattern.

In an embodiment, the display device may further include a color conversion pattern disposed in the first opening and including a quantum dot.

In an embodiment, the liquid-repellent pattern may cover the upper surface and a side surface of the bank pattern.

In an embodiment, the color conversion pattern may be in contact with a portion of the liquid-repellent pattern in the first opening.

In an embodiment, the display device may further include a light emitting layer disposed between the substrate and the bank pattern.

In an embodiment, the display device may further include a color filter layer disposed between the substrate and the bank pattern.

In an embodiment, the first light emitting area may emit light in a red wavelength band, the second light emitting area may emit light in a green wavelength band, and the third light emitting area may emit light in a blue wavelength band.

In order to achieve one object of the present invention described above, a display device according to an embodiment of the invention may include a substrate, where a first light emitting area, a second light emitting area, and a third light emitting area, which emit light in different wavelength bands, respectively, are defined on the substrate, a bank pattern disposed on the substrate and defining a first opening overlapping the first light emitting area, a second opening overlapping the second light emitting area, and a third opening overlapping the third light emitting area, and a liquid-repellent pattern filling the third opening and disposed on at least a portion of an upper surface of the bank pattern, where the liquid-repellent pattern includes a liquid-repellent material.

In an embodiment, the liquid-repellent pattern may further include a scatterer.

In an embodiment, the display device may further include a reflective pattern disposed between the bank pattern and the liquid-repellent pattern.

In an embodiment, the reflective pattern may cover the upper surface and a side surface of the bank pattern.

In an embodiment, the liquid-repellent pattern may include a first portion filling the third opening and disposed on at least a portion of the upper surface of the bank pattern adjacent to the third opening, and a second portion disposed on at least a portion of the upper surface of the bank pattern between the first opening and the second opening.

In an embodiment, the display device may further include a first color conversion pattern disposed in the first opening and including a first quantum dot, and a second color conversion pattern disposed in the second opening and including a second quantum dot.

In an embodiment, the liquid-repellent pattern may cover the upper surface and a side surface of the bank pattern.

In an embodiment, the first color conversion pattern may be in contact with a portion of the liquid-repellent pattern in the first opening, and the second color conversion pattern may be in contact with a portion of the liquid-repellent pattern in the second opening.

In an embodiment, the display device may further include a light emitting layer disposed between the substrate and the bank pattern.

In an embodiment, the display device may further include a color filter layer disposed between the substrate and the bank pattern.

In an embodiment, the first light emitting area may emit light in a red wavelength band, the second light emitting area may emit light in a green wavelength band, and the third light emitting area may emit light in a blue wavelength band.

### [Advantageous Effects]

In a display device according to embodiments of the invention, the display device may include a liquid-repellent pattern covering an upper surface of a bank pattern while filling at least one of openings defined by the bank pattern. The liquid-repellent pattern may include a liquid-repellent material and a scatterer, and accordingly, a width of the bank pattern may be allowed to be reduced. In such embodiments, as an area occupied by the bank pattern is reduced, display quality and efficiency in a manufacturing process of the display device may be improved, and the display device may be implemented as a high-resolution display device.

However, the effects of the present invention are not limited to the above effects, and may be expanded in various ways without departing from the spirit and scope of the present invention.

### [Description of Drawings]

Figure 1 is a perspective view illustrating a display device according to an embodiment of the invention.
Figure 2 is a cross-sectional view taken along line I-I' of Figure 1.
Figure 3 is a cross-sectional view taken along line II-II' of Figure 1.
Figure 4 is an enlarged plan view of area A of Figure 3.
Figure 5 is a cross-sectional view illustrating a display device according to an embodiment of the invention.
Figure 6 is an enlarged plan view of area B of Figure 5.
Figure 7 is a cross-sectional view illustrating a display device according to an embodiment of the invention.
Figure 8 is an enlarged plan view of area C of Figure 7.
Figure 9 is a cross-sectional view illustrating a display device according to an embodiment of the invention.
Figure 10 is an enlarged plan view of area D of Figure 9.
Figure 11 is a cross-sectional view illustrating a display device according to an embodiment of the invention.

### [Best Mode]

### [Mode for Invention]

Hereinafter, with reference to the attached drawings, embodiments of the present invention will be described in more detail. The same reference numerals will be used for the same components in the drawings, and duplicate descriptions of the same components will be omitted.

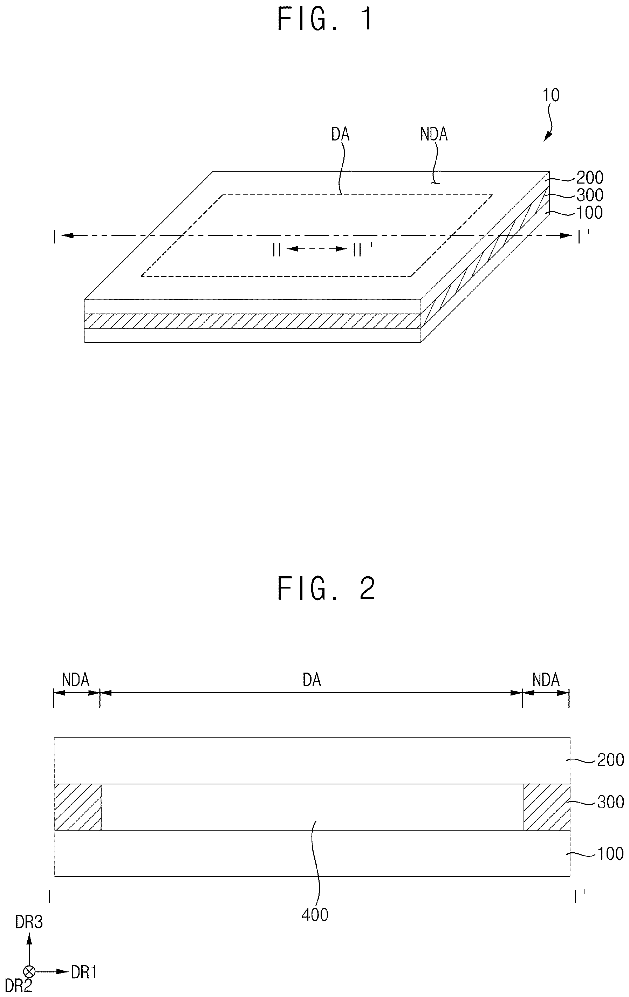

Figure 1 is a perspective view illustrating a display device according to an embodiment of the invention.
Referring to Figure 1, an embodiment of a display device 10 may include a display area DA and a non-display area NDA.

A plurality of pixels may be disposed in the display area DA and may not be disposed in the non-display area NDA. The plurality of pixels may be arranged in a first direction DR1 and a second direction DR2 intersecting the first direction DR1. For example, the first direction DR1 may be perpendicular to the second direction DR2. Each of the plurality of pixels may emit light. As each of the plurality of pixels emits light, the display area DA may display an image.

Lines connected to the plurality of pixels may be further disposed in the display area DA. In an embodiment, for example, the lines may include a data signal line, a gate signal line, a power line, or the like.

The non-display area NDA may be an area that does not display an image. The non-display area NDA may be disposed around the display area DA. In an embodiment, for example, the non-display area NDA may surround the display area DA in a plan view or when viewed in a third direction DR3. Here, the third direction DR3 may be a direction perpendicular to the first direction DR1 and the second direction DR2, or a thickness direction of the display device 10.

Drivers for driving the plurality of pixels may be disposed in the non-display area NDA. In an embodiment, for example, the drivers may include a data driver, a gate driver, a power voltage generator, a timing controller, or the like. The plurality of pixels may emit light based on signals received from the drivers.

Figure 2 is a cross-sectional view taken along line I-I' of Figure 1.

Referring to Figures 1 and 2, an embodiment of the display device 10 may include a first structure 100, a second structure 200, and a sealing member 300.

The second structure 200 may be disposed on the first structure 100. The first structure 100 and the second structure 200 may be disposed opposite to each other. The second structure 200 may be spaced apart from the first structure 100 in a third direction DR3 intersecting each of the first direction DR1 and the second direction DR2. In an embodiment, for example, the third direction DR3 may be perpendicular to each of the first direction DR1 and the second direction DR2.

Accordingly, in such an embodiment, a space 400 may be defined between the first structure 100 and the second structure 200. The space 400 may maintain a gap between the first structure 100 and the second structure 200. In an embodiment, the space 400 may be filled with a filler. In an embodiment, for example, the filler may include an organic material such as a silicone resin, an epoxy resin, or the like, air, or the like. In addition, the filler may further include a material for matching a refractive index. In another embodiment, the space 400 may be in a vacuum state.

The first structure 100 may be a substrate including a light emitting element. The light emitting element may be disposed in the display area DA, and may generate light based on a driving signal. The second structure 200 may be a substrate including a color filter layer. The color filter layer may selectively transmit light of a specific wavelength band.

The sealing member 300 may be disposed between the first structure 100 and the second structure 200. The sealing member 300 may be disposed along the non-display area NDA. The sealing member 300 may be disposed along edges of the first structure 100 and the second structure 200 in the non-display area NDA. That is, the sealing member 300 may be disposed between the first structure 100 and the second structure 200 to surround the display area DA in a plan view. The first structure 100 and the second structure 200 may be coupled by the sealing member 300.

Since the space 400 between the first structure 100 and the second structure 200 is sealed by the sealing member 300, external moisture, air, impurities, or the like may be effectively prevented from penetrating into the space 400. In addition, the sealing member 300 may maintain the space 400 between the first structure 100 and the second structure 200. In an embodiment, for example, the sealing member 300 may include an organic material such as an epoxy resin or the like.

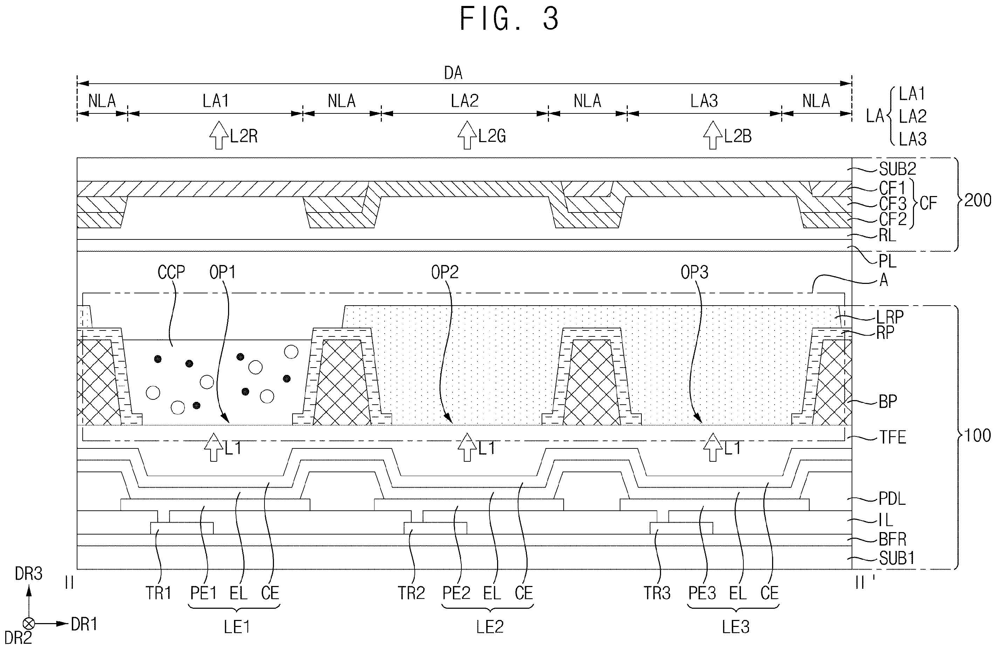

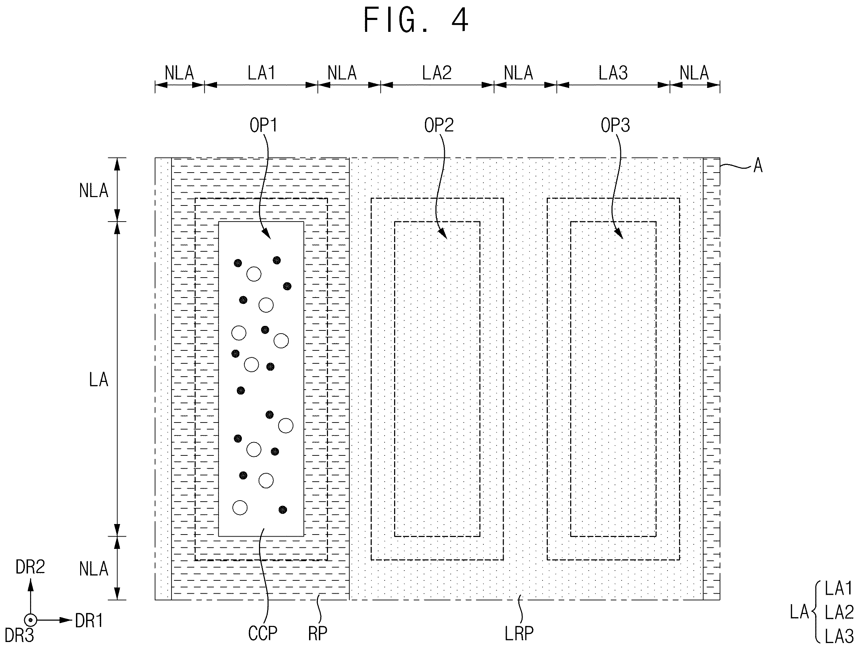

Figure 3 is a cross-sectional view taken along line II-II' of Figure 1. Figure 4 is an enlarged plan view of area A of Figure 3. Particularly, Figures 3 and 4 may be views illustrating an example of the display area DA included in the display device 10.

Referring to Figures 1, 2, 3, and 4, an embodiment of the display area DA may include a light emitting area LA and a non-light emitting area NLA. The light emitting area LA may be an area that emits light, and the non-light emitting area NLA may be an area that does not emit light.

Light (hereinafter, incident light) L1 generated in the first structure 100 may be emitted to the outside through the light emitting area LA. In an embodiment, for example, the incident light L1 may be emitted in the third direction DR3 through the light emitting area LA. The light emitting area LA may include a first light emitting area LA1, a second light emitting area LA2, and a third light emitting area LA3.

The first, second, and third light emitting areas LA1, LA2, and LA3 may emit light in different wavelength bands, respectively. The first light emitting area LA1 may emit a first transmitted light L2R, the second light emitting area LA2 may emit a second transmitted light L2G, and the third light emitting area LA3 may emit a third transmitted light L2B. In an embodiment, for example, the first light emitting area LA1 may emit the first transmitted light L2R in a red wavelength band, the second light emitting area LA2 may emit the second transmitted light L2G in a green wavelength band, and the third light emitting area LA3 may emit the third transmitted light L2B in a blue wavelength band, but the invention is not limited thereto.

In an embodiment, the first, second, and third light emitting areas LA1, LA2, and LA3 may be spaced apart from each other in a plan view, and may be disposed to be repeatedly arranged in a predetermined manner. The non-light emitting area NLA may be disposed between the first, second, and third light emitting areas LA1, LA2, and LA3 adjacent to each other. The non-light emitting area NLA may surround the first, second, and third light emitting areas LA1, LA2, and LA3 in a plan view. In an embodiment, for example, the non-light emitting area NLA may have a grid shape in a plan view.

In an embodiment, the first structure 100 may include a first substrate SUB1, a buffer layer BFR, first, second, and third transistors TR1, TR2, and TR3, an insulating layer IL, a pixel defining layer PDL, first, second, and third light emitting elements LE1, LE2, and LE3, an encapsulation layer TFE, a bank pattern BP, a reflective pattern RP, a liquid-repellent pattern LRP, and a color conversion pattern CCP.

In such an embodiment, the first light emitting element LE1 may include a first pixel electrode PE1, a light emitting layer EL, and a common electrode CE, the second light emitting element LE2 may include a second pixel electrode PE2, the light emitting layer EL, and the common electrode CE, and the third light emitting element LE3 may include a third pixel electrode PE3, the light emitting layer EL, and the common electrode CE.

The first substrate SUB1 may include a transparent material or an opaque material. In an embodiment, for example, the first substrate SUB1 may include a glass substrate, a plastic substrate, a flexible film, a metal substrate, or the like. These may be used alone or in combination with each other. Since the display area DA of the display device 10 includes the first, second, and third light emitting areas LA1, LA2, and LA3 and the non-light emitting area NLA, the first, second, and third light emitting areas LA1, LA2, and LA3 and the non-light emitting area NLA may also be defined in the first substrate SUB1.

The buffer layer BFR may be disposed on the first substrate SUB1. The buffer layer BFR may effectively prevent a metal atom, impurities, or the like from being diffused from the first substrate SUB1 to the first, second, and third transistors TR1, TR2, and TR3. In addition, the buffer layer BFR may improve a flatness of a surface of the first substrate SUB1 when the surface of the first substrate SUB1 is not uniform. In an embodiment, for example, the buffer layer BFR may include an inorganic material such as silicon oxide (SiOx), silicon nitride (SiNx), silicon oxynitride (SiOxNy), or the like. These may be used alone or in combination with each other.

The first, second, and third transistors TR1, TR2, and TR3 may be disposed on the buffer layer BFR. A channel layer of each of the first, second, and third transistors TR1, TR2, and TR3 may include a silicon semiconductor material or an oxide semiconductor material. Examples of the silicon semiconductor material may include amorphous silicon, polycrystalline silicon, or the like. Examples of the oxide semiconductor material may include indium gallium zinc oxide (IGZO), indium tin zinc oxide (ITZO), or the like. These may be used alone or in combination with each other.

The insulating layer IL may be disposed on the buffer layer BFR, and may cover the first, second, and third transistors TR1, TR2, and TR3. In an embodiment, for example, the insulating layer IL may include an inorganic material such as silicon oxide, silicon nitride, silicon oxynitride, or the like. In an embodiment, for example, the insulating layer IL may include an organic material such as a phenol resin, an acrylic resin, a polyimide resin, a polyamide resin, a siloxane resin, an epoxy resin, or the like. These may be used alone or in combination with each other.

The first, second, and third pixel electrodes PE1, PE2, and PE3 may be disposed on the insulating layer IL. The first, second, and third pixel electrodes PE1, PE2, and PE3 may overlap the first, second, and third light emitting areas LA1, LA2, and LA3, respectively. In the invention, when two elements overlap each other, the two elements may overlap each other in a plan view or in the third direction DR3 (i.e., a thickness direction of the first substrate SUB1). The first, second, and third pixel electrodes PE1, PE2, and PE3 may be connected to the first, second, and third transistors TR1, TR2, and TR3, respectively, through contact holes defined or formed in the insulating layer IL. In an embodiment, for example, each of the first, second, and third pixel electrodes PE1, PE2, and PE3 may include a metal, an alloy, a conductive metal nitride, a conductive metal oxide, a transparent conductive material, or the like. These may be used alone or in combination with each other.

The pixel defining layer PDL may be disposed on the insulating layer IL, and may overlap the non-light emitting area NLA. The pixel defining layer PDL may cover at least a portion of each of the first, second, and third pixel electrodes PE1, PE2, and PE3. The pixel defining layer PDL may define an opening exposing at least a portion of an upper surface of each of the first, second, and third pixel electrodes PE1, PE2, and PE3. The pixel defining layer PDL may include an organic material such as an epoxy resin, a siloxane resin, or the like.

The light emitting layer EL may be disposed on the first, second, and third pixel electrodes PE1, PE2, and PE3 exposed by the pixel defining layer PDL and the pixel defining layer PDL. In an embodiment, the light emitting layer EL may continuously extend in the display area DA across a plurality of pixels. In an embodiment, for example, the light emitting layer EL may entirely overlap the first, second, and third light emitting areas LA1, LA2, and LA3 and the non-light emitting area NLA. In another embodiment, the light emitting layer EL may be separated from a light emitting layer of an adjacent pixel. In an embodiment, for example, the light emitting layer EL may overlap the first, second, and third light emitting areas LA1, LA2, and LA3, and may not overlap the non-light emitting area NLA.

The light emitting layer EL may include at least one selected from an organic material and a quantum dot that emit light of a predetermined color. In an embodiment, for example, the light emitting layer EL may emit light in a blue wavelength band or light in a green wavelength band, but the invention is not limited thereto. T he light emitting layer EL may have a multi-layered structure. Functional layers such as a hole injection layer, a hole transport layer, an electron transport layer, an electron injection layer, or the like may be disposed on or below the light emitting layer EL.

In an embodiment, the light emitting layer EL may have a structure in which a plurality of organic light emitting layers that emit light in different wavelength bands are stacked. In an embodiment, for example, the light emitting layer EL may have a structure in which a blue organic light emitting layer that emits light in a blue wavelength band and a green organic light emitting layer that emits light in a green wavelength band are stacked. In such an embodiment, the light emitting layer EL may emit light in a blue wavelength band and light in a green wavelength band, and the incident light L1 may be light in a blue wavelength band and light in a green wavelength band. In an embodiment, for example, the light emitting layer EL may have a structure in which three blue organic light emitting layers that each emits light in a blue wavelength band and one green organic light emitting layer that emits light in a green wavelength band are stacked, but the invention is not limited thereto.

In another embodiment, the light emitting layer EL may have a structure in which a plurality of organic light emitting layers that emit light in a same wavelength band are stacked. In an embodiment, for example, the light emitting layer EL may have a structure in which a plurality of blue organic light emitting layers that each emits light in a blue wavelength band are stacked. In such an embodiment, the light emitting layer EL may emit light in a blue wavelength band, and the incident light L1 may be light in a blue wavelength band. In an embodiment, for example, the light emitting layer EL may have a structure in which three blue organic light emitting layers that each emits light in a blue wavelength band are stacked, but the invention is not limited thereto.

The common electrode CE may be disposed on the light emitting layer EL. The common electrode CE may continuously extend or commonly provided in the display area DA across a plurality of pixels. In an embodiment, for example, the common electrode CE may entirely overlap the first, second, and third light emitting areas LA1, LA2, and LA3 and the non-light emitting area NLA. In an embodiment, for example, the common electrode CE may include a metal, an alloy, a conductive metal nitride, a conductive metal oxide, a transparent conductive material, or the like. These may be used alone or in combination with each other.

Accordingly, the first light emitting element LE1 including the first pixel electrode PE1, the light emitting layer EL, and the common electrode CE may be disposed in the first light emitting area LA1 on the first substrate SUB1. The second light emitting element LE2 including the second pixel electrode PE2, the light emitting layer EL, and the common electrode CE may be disposed in the second light emitting area LA2 on the first substrate SUB1. The third light emitting element LE3 including the third pixel electrode PE3, the light emitting layer EL, and the common electrode CE may be disposed in the third light emitting area LA3 on the first substrate SUB1. Each of the first, second, and third light emitting elements LE1, LE2, and LE3 may emit the incident light L1 in a direction toward the second structure 200 (i.e., in the third direction DR3).

The encapsulation layer TFE may be disposed on the common electrode CE. The encapsulation layer TFE may protect the first, second, and third light emitting elements LE1, LE2, and LE3 from external oxygen and moisture. The encapsulation layer TFE may include at least one inorganic layer and at least one organic layer.

The bank pattern BP may be disposed on the encapsulation layer TFE. The bank pattern BP may overlap the non-light emitting area NLA. The bank pattern BP may include a light blocking material, and may block light emitted from a lower component. In an embodiment, for example, the bank pattern BP may include an organic material including a light blocking material such as a black pigment, a black dye, carbon black, or the like.

The bank pattern BP may define (or be provided with) openings exposing the encapsulation layer TFE. The bank pattern BP may define a first opening OP1 overlapping the first light emitting area LA1, a second opening OP2 overlapping the second light emitting area LA2, and a third opening OP3 overlapping the third light emitting area LA3.

The reflective pattern RP may be disposed on the bank pattern BP. The reflective pattern RP may overlap the non-light emitting area NLA. In an embodiment, the reflective pattern RP may cover an upper surface and a side surface of the bank pattern BP. The reflective pattern RP may extend from the upper surface to the side surface to entirely cover the bank pattern BP in a plan view. That is, the reflective pattern RP may continuously extend without being disconnected on the bank pattern BP. The reflective pattern RP may include a metal. In an embodiment, for example, the reflective pattern RP may include aluminum (Al), silver (Ag), gold (Au), or the like. However, the invention is not limited thereto, and the reflective pattern RP may include various materials having relatively high reflectivity.

The reflective pattern RP may reflect light incident on the reflective pattern RP. In an embodiment, for example, the reflective pattern RP may reflect the incident light L1 incident on the reflective pattern RP, light emitted by the color conversion pattern CCP, or light emitted by the liquid-repellent pattern LRP, thereby improving light extraction efficiency of the display device 10. In an embodiment, for example, the reflective pattern RP may improve light extraction efficiency of the display device 10 by reflecting light that deviates from an optical path.

The liquid-repellent pattern LRP may be disposed on the reflective pattern RP. In an embodiment, the liquid-repellent pattern LRP may fill the second opening OP2 and the third opening OP3. In addition, the liquid-repellent pattern LRP may be disposed on at least a portion of the upper surface of the bank pattern BP. The liquid-repellent pattern LRP may be disposed in the second opening OP2 and the third opening OP3, may cover the upper surface of the bank pattern BP between the second opening OP2 and the third opening OP3, and may cover at least a portion of the upper surface of the bank pattern BP adjacent to the first opening OP1. The liquid-repellent pattern LRP may overlap the second and third light emitting areas LA2 and LA3 and the non-light emitting area NLA in a plan view.

The liquid-repellent pattern LRP may include a transparent material. In an embodiment, for example, the liquid-repellent pattern LRP may include an organic material such as an acrylic resin, an epoxy resin, a polyimide resin, a polyamide resin, or the like. These may be used alone or in combination with each other. In such an embodiment, where the liquid-repellent pattern LRP includes a transparent material, the liquid-repellent pattern LRP may transmit light incident on the liquid-repellent pattern LRP (e.g., the incident light L1).

In an embodiment, the liquid-repellent pattern LRP may include a liquid-repellent material. The liquid-repellent material may have a liquid-repellent property with respect to a material included in the color conversion pattern CCP. In an embodiment, the liquid-repellent pattern LRP may further include a scatterer. In such an embodiment where the liquid-repellent pattern LRP includes the scatterer, the liquid-repellent pattern LRP may scatter light incident on the liquid-repellent pattern LRP (e.g., the incident light L1). In an embodiment, for example, the liquid-repellent pattern LRP may be formed through a photolithography process.

The color conversion pattern CCP may be disposed in the first opening OP1. The color conversion pattern CCP may convert light incident on the color conversion pattern CCP (e.g., the incident light L1) into light of a specific wavelength band. I n an embodiment, the color conversion pattern CCP may convert the incident light L1 into the first transmitted light L2R and emit the first transmitted light L2R. The color conversion pattern CCP may include quantum dots that are excited by the incident light L1 and emit the first transmitted light L2R. In addition, the color conversion pattern CCP may further include scatterers and a photosensitive polymer in which the scatterers are dispersed. In an embodiment, for example, as the incident light L1 passes through the color conversion pattern CCP, the first transmitted light L2R in a red wavelength band may be emitted from the first light emitting area LA1, but the invention is not limited thereto.

The color conversion pattern CCP may be formed through a different process from the liquid-repellent pattern LRP. In an embodiment, for example, the color conversion pattern CCP may be formed through an inkjet process. In such an embodiment, ink that forms the color conversion pattern CCP may be effectively prevented from penetrating into other spaces by the liquid-repellent pattern LRP, and a surface shape of the color conversion pattern CCP may be maintained.

In an embodiment, the second structure 200 may include a second substrate SUB2, a color filter layer CF, a refractive layer RL, and a protective layer PL. The second structure 200 may be disposed opposite to the first structure 100 with the space 400 interposed therebetween.

The second substrate SUB2 may include a transparent material or an opaque material. In an embodiment, for example, the second substrate SUB2 may include a glass substrate, a plastic substrate, a flexible film, a metal substrate, or the like. These may be used alone or in combination with each other. Since the display area DA of the display device 10 includes the first, second, and third light emitting areas LA1, LA2, and LA3 and the non-light emitting area NLA, the first, second, and third light emitting areas LA1, LA2, and LA3 and the non-light emitting area NLA may also be defined in the second substrate SUB.

The color filter layer CF may be disposed below the second substrate SUB2. The color filter layer CF may include a first color filter CF1, a second color filter CF2, and a third color filter CF3.

The first color filter CF1 may overlap the first light emitting area LA1, the second color filter CF2 may overlap the second light emitting area LA2, and the third color filter CF3 may overlap the third light emitting area LA3. Each of the first, second, and third color filters CF1, CF2, and CF3 may selectively transmit light of a specific wavelength band.

The first color filter CF1 may transmit the first transmitted light L2R, and may block light in a wavelength band different from that of the first transmitted light L2R. In an embodiment, for example, the first color filter CF1 may transmit only the first transmitted light L2R in a red wavelength band, but the invention is not limited thereto. Accordingly, in the first light emitting area LA1, the first transmitted light L2R may pass through the second substrate SUB2 and be emitted to the outside (i.e., in the third direction DR3).

The second color filter CF2 may transmit the second transmitted light L2G, and may block light in a wavelength band different from that of the second transmitted light L2G. In an embodiment, for example, the second color filter CF2 may transmit only the second transmitted light L2G in a green wavelength band, but the invention is not limited thereto. Accordingly, in the second light emitting area LA2, the second transmitted light L2G may pass through the second substrate SUB2 and be emitted to the outside (i.e., in the third direction DR3).

The third color filter CF3 may transmit the third transmitted light L2B, and may block light in a wavelength band different from that of the third transmitted light L2B. In an embodiment, for example, the third color filter CF3 may transmit only the third transmitted light L2B in a blue wavelength band, but the invention is not limited thereto. Accordingly, in the third light emitting area LA3, the third transmitted light L2B may pass through the second substrate SUB2 and be emitted to the outside (i.e., in the third direction DR3).

In an embodiment, each of the first, second, and third color filters CF1, CF2, and CF3 may overlap the non-light emitting area NLA. The first color filter CF1 may overlap the first light emitting area LA1 and the non-light emitting area NLA, and may not overlap the second and third light emitting areas LA2 and LA3. The second color filter CF2 may overlap the second light emitting area LA2 and the non-light emitting area NLA, and may not overlap the first and third light emitting areas LA1 and LA3. The third color filter CF3 may overlap the third light emitting area LA3 and the non-light emitting area NLA, and may not overlap the first and second light emitting areas LA1 and LA2.

In such an embodiment, in the non-light emitting area NLA, the first, second, and third color filters CF1, CF2, and CF3 may overlap each other in the third direction DR3. In an embodiment, for example, in the non-light emitting area NLA, the third color filter CF3 may be disposed below the first color filter CF1, and the second color filter CF2 may be disposed below the third color filter CF3. Accordingly, color mixing between the first, second, and third light emitting areas LA1, LA2, and LA3 adjacent to each other may be effectively prevented.

The refractive layer RL may be disposed below the color filter layer CF. The refractive layer RL may increase light extraction efficiency to increase luminance and lifespan of the display device 10. In an embodiment, for example, the refractive layer RL may include an organic material.

The protective layer PL may be disposed below the refractive layer RL. The protective layer PL may cover a lower surface of the refractive layer RL. In an embodiment, for example, the protective layer PL may include an inorganic material such as silicon oxide, silicon nitride, silicon oxynitride, or the like. These may be used alone or in combination with each other.

The display device 10 according to an embodiment of the invention may include the liquid-repellent pattern LRP covering the upper surface of the bank pattern BP while filling the second and third openings OP2 and OP3 defined by the bank pattern BP. The liquid-repellent pattern LRP may include a liquid-repellent material and a scatterer, and accordingly, a width of the bank pattern BP may be reduced. As an area occupied by the bank pattern BP is reduced, display quality and process efficiency of the display device 10 may be improved, and the display device 10 may be implemented as a high-resolution display device.

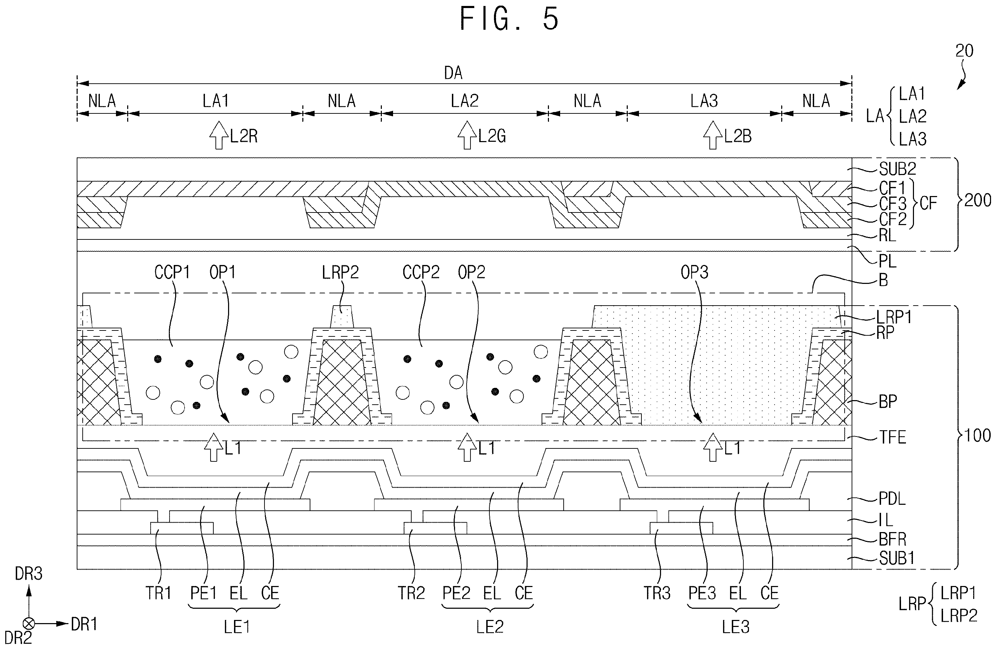

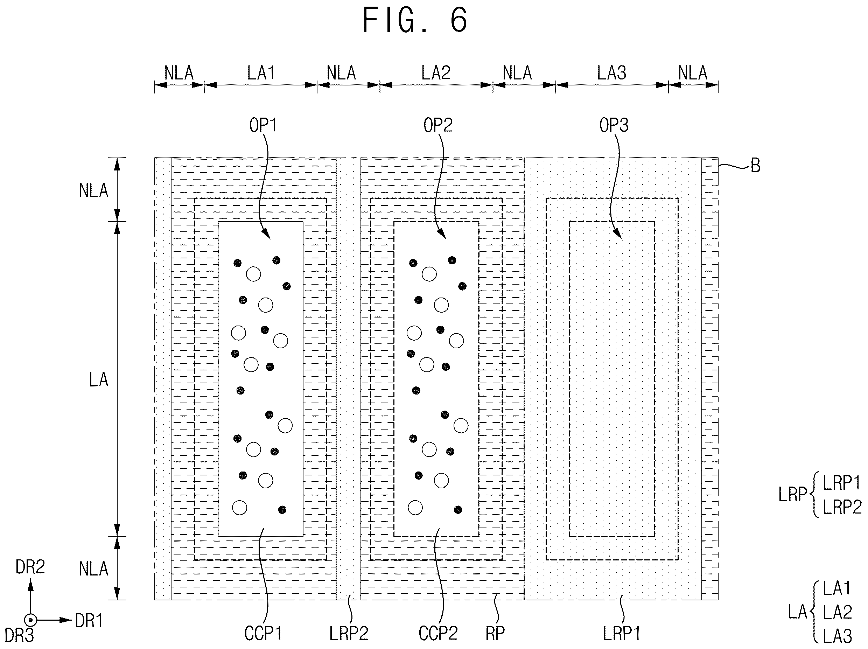

Figure 5 is a cross-sectional view illustrating a display device according to an embodiment of the invention. Figure 6 is an enlarged plan view of area B of Figure 5. Particularly, Figure 5 may correspond to the cross-sectional view of Figure 3, and Figure 6 may correspond to the plan view of Figure 4. That is, Figures 5 and 6 may be views illustrating an example of a display area DA included in a display device 20.

The display device 20 described with reference to Figures 5 and 6 may be substantially the same as or similar to the display device 10 described with reference to Figures 1 to 4 except for the color conversion pattern CCP and the liquid-repellent pattern LRP. The same or like elements shown in Figures 5 and 6 have been labeled with the same reference characters as used above to describe the embodiments of the display device 10 described with reference to Figures 1 to 4, and any repetitive detailed descriptions thereof will hereinafter be omitted or simplified.

Referring to Figures 5 and 6, an embodiment of the display device 20 may include the display area DA, and the display area DA may include a first light emitting area LA1, a second light emitting area LA2, a third light emitting area LA3, and a non-light emitting area NLA. The non-light emitting area NLA may be disposed between the first, second, and third light emitting areas LA1, LA2, and LA3 adjacent to each other.

The display device 20 may include a first structure 100 and a second structure 200 which are disposed opposite to each other. The second structure 200 may be spaced apart from the first structure 100 in a third direction DR3. Incident light L1 generated in the first structure 100 may be emitted to the outside (i.e., in the third direction DR3) through the first, second, and third light emitting areas LA1, LA2, and LA3.

The first, second, and third light emitting areas LA1, LA2, and LA3 may emit light in different wavelength bands. In an embodiment, for example, the first light emitting area LA1 may emit a first transmitted light L2R in a red wavelength band, the second light emitting area LA2 may emit a second transmitted light L2G in a green wavelength band, and the third light emitting area LA3 may emit a third transmitted light L2B in a blue wavelength band, but the invention is not limited thereto.

In an embodiment, the first structure 100 may include a first substrate SUB1, a buffer layer BFR, first, second, and third transistors TR1, TR2, and TR3, an insulating layer IL, a pixel defining layer PDL, first, second, and third light emitting elements LE1, LE2, and LE3, an encapsulation layer TFE, a bank pattern BP, a reflective pattern RP, a liquid-repellent pattern LRP, a first color conversion pattern CCP1, and a second color conversion pattern CCP2.

Here, the first light emitting element LE1 may include a first pixel electrode PE1, a light emitting layer EL, and a common electrode CE, the second light emitting element LE2 may include a second pixel electrode PE2, the light emitting layer EL, and the common electrode CE, and the third light emitting element LE3 may include a third pixel electrode PE3, the light emitting layer EL, and the common electrode CE.

The buffer layer BFR, the first, second, and third transistors TR1, TR2, and TR3, the insulating layer IL, the first, second, and third pixel electrodes PE1, PE2, and PE3, the pixel defining layer PDL, the light emitting layer EL, the common electrode CE, and the encapsulation layer TFE may be sequentially disposed on the first substrate SUB1.

The bank pattern BP may be disposed in the non-light emitting area NLA on the encapsulation layer TFE. The bank pattern BP may define a first opening OP1 overlapping the first light emitting area LA1, a second opening OP2 overlapping the second light emitting area LA2, and a third opening OP3 overlapping the third light emitting area LA3.

The reflective pattern RP may be disposed on the bank pattern BP. The reflective pattern RP may cover an upper surface and a side surface of the bank pattern BP. The reflective pattern RP may entirely cover the bank pattern BP in a plan view. The reflective pattern RP may include a material having a relatively high reflectivity, and may reflect light incident on the reflective pattern RP.

The liquid-repellent pattern LRP may be disposed on the reflective pattern RP. In an embodiment, the liquid-repellent pattern LRP may fill the third opening OP3. In addition, the liquid-repellent pattern LRP may be disposed on at least a portion of the upper surface of the bank pattern BP.

The liquid-repellent pattern LRP may include a first portion LRP1 disposed in the third opening OP3 and covering at least a portion of the upper surface of the bank pattern BP adjacent to the third opening OP3, and a second portion LRP2 covering at least a portion of the upper surface of the bank pattern BP between the first opening OP1 and the second opening OP2. The liquid-repellent pattern LRP may overlap the third light emitting area LA3 and the non-light emitting area NLA.

The liquid-repellent pattern LRP may include a transparent material, and may transmit light incident on the liquid-repellent pattern LRP. In an embodiment, the liquid-repellent pattern LRP may include a liquid-repellent material and a scatterer. The liquid-repellent material may have a liquid-repellent property with respect to a material included in the first and second color conversion patterns CCP1 and CCP2, and the scatterer may scatter light incident on the liquid-repellent pattern LRP. In an embodiment, for example, the liquid-repellent pattern LRP may be formed through a photolithography process.

The first color conversion pattern CCP1 may be disposed in the first opening OP1. The first color conversion pattern CCP1 may convert light incident on the first color conversion pattern CCP1 into light of a specific wavelength band. In an embodiment, the first color conversion pattern CCP1 may convert the incident light L1 into the first transmitted light L2R and emit the first transmitted light L2R. The first color conversion pattern CCP1 may include first quantum dots that are excited by the incident light L1 and emit the first transmitted light L2R. In addition, the first color conversion pattern CCP1 may further include first scatterers and a first photosensitive polymer in which the first scatterers are dispersed. In an embodiment, for example, as the incident light L1 passes through the first color conversion pattern CCP1, the first transmitted light L2R in a red wavelength band may be emitted from the first light emitting area LA1, but the invention is not limited thereto.

The second color conversion pattern CCP2 may be disposed in the second opening OP2. The second color conversion pattern CCP2 may convert light incident on the second color conversion pattern CCP2 into light of a specific wavelength band. In an embodiment, the second color conversion pattern CCP2 may convert the incident light L1 into the second transmitted light L2G and emit the second transmitted light L2G. The second color conversion pattern CCP2 may include second quantum dots that are excited by the incident light L1 and emit the second transmitted light L2G. In addition, the second color conversion pattern CCP2 may further include second scatterers and a second photosensitive polymer in which the second scatterers are dispersed. In an embodiment, for example, as the incident light L1 passes through the second color conversion pattern CCP2, the second transmitted light L2G in a green wavelength band may be emitted from the second light emitting area LA2, but the invention is not limited thereto.

In an embodiment, for example, the first and second color conversion patterns CCP1 and CCP2 may be formed through an inkjet process. In such an embodiment, ink that forms each of the first and second color conversion patterns CCP1 and CCP2 may be effectively prevented from penetrating into other spaces by the liquid-repellent pattern LRP, and a surface shape of each of the first and second color conversion patterns CCP1 and CCP2 may be maintained.

In an embodiment, the second structure 200 may include a second substrate SUB2, a color filter layer CF, a refractive layer RL, and a protective layer PL. The color filter layer CF may include a first color filter CF1, a second color filter CF2, and a third color filter CF3. The color filter layer CF, the refractive layer RL, and the protective layer PL may be sequentially disposed below the second substrate SUB2.

The display device 20 according to an embodiment of the invention may include the liquid-repellent pattern LRP covering the upper surface of the bank pattern BP while filling the third opening OP3 defined by the bank pattern BP. The liquid-repellent pattern LRP may include a liquid-repellent material and a scatterer, and accordingly, a width of the bank pattern BP may be reduced. As an area occupied by the bank pattern BP is reduced, display quality and process efficiency of the display device 20 may be improved, and the display device 20 may be implemented as a high-resolution display device.

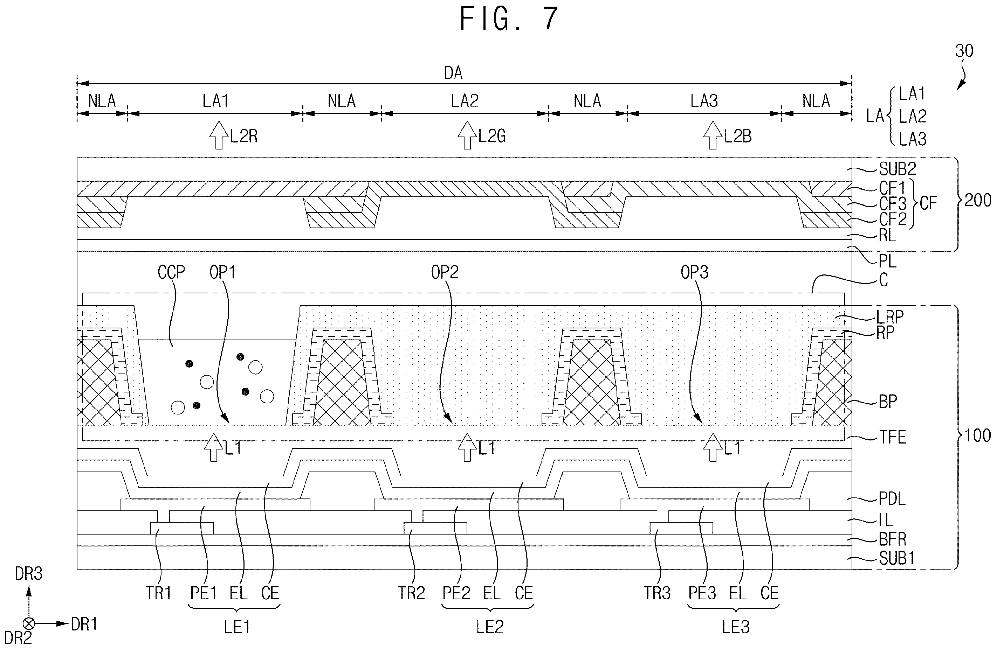

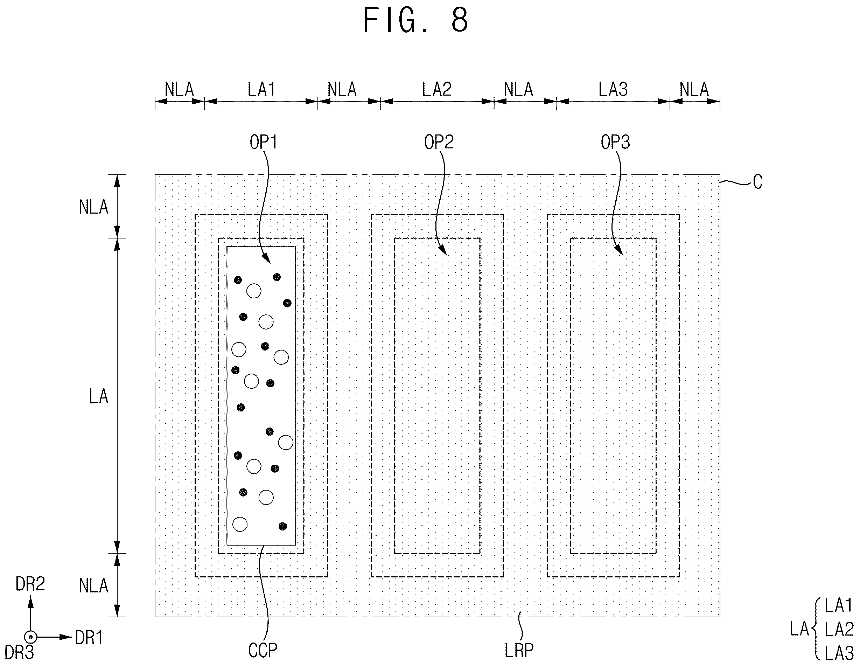

Figure 7 is a cross-sectional view illustrating a display device according to an embodiment of the invention. Figure 8 is an enlarged plan view of area C of Figure 7. Particularly, Figure 7 may correspond to the cross-sectional view of Figure 3, and Figure 8 may correspond to the plan view of Figure 4. That is, Figures 7 and 8 may be views illustrating an example of a display area DA included in a display device 30.

The display device 30 described with reference to Figures 7 and 8 may be substantially the same as or similar to the display device 10 described with reference to Figures 1, 2, 3, and 4 except for a shape of the liquid-repellent pattern LRP. The same or like elements shown in Figures 7 and 8 have been labeled with the same reference characters as used above to describe the embodiments of the display device 10 described with reference to Figures 1 to 4, and any repetitive detailed descriptions thereof will hereinafter be omitted or simplified.

Referring to Figures 7 and 8, an embodiment of the display device 30 may include the display area DA, and the display area DA may include a first light emitting area LA1, a second light emitting area LA2, a third light emitting area LA3, and a non-light emitting area NLA. The non-light emitting area NLA may be disposed between the first, second, and third light emitting areas LA1, LA2, and LA3 adjacent to each other.

The display device 30 may include a first structure 100 and a second structure 200 which are disposed opposite to each other. The second structure 200 may be spaced apart from the first structure 100 in a third direction DR3. Incident light L1 generated in the first structure 100 may be emitted to the outside (i.e., in the third direction DR3) through the first, second, and third light emitting areas LA1, LA2, and LA3.

The first, second, and third light emitting areas LA1, LA2, and LA3 may emit light in different wavelength bands. In an embodiment, for example, the first light emitting area LA1 may emit a first transmitted light L2R in a red wavelength band, the second light emitting area LA2 may emit a second transmitted light L2G in a green wavelength band, and the third light emitting area LA3 may emit a third transmitted light L2B in a blue wavelength band, but the invention is not limited thereto.

In an embodiment, the first structure 100 may include a first substrate SUB1, a buffer layer BFR, first, second, and third transistors TR1, TR2, and TR3, an insulating layer IL, a pixel defining layer PDL, first, second, and third light emitting elements LE1, LE2, and LE3, an encapsulation layer TFE, a bank pattern BP, a reflective pattern RP, a liquid-repellent pattern LRP, and a color conversion pattern CCP.

Here, the first light emitting element LE1 may include a first pixel electrode PE1, a light emitting layer EL, and a common electrode CE, the second light emitting element LE2 may include a second pixel electrode PE2, the light emitting layer EL, and the common electrode CE, and the third light emitting element LE3 may include a third pixel electrode PE3, the light emitting layer EL, and the common electrode CE.

The buffer layer BFR, the first, second, and third transistors TR1, TR2, and TR3, the insulating layer IL, the first, second, and third pixel electrodes PE1, PE2, and PE3, the pixel defining layer PDL, the light emitting layer EL, the common electrode CE, and the encapsulation layer TFE may be sequentially disposed on the first substrate SUB1.

The bank pattern BP may be disposed in the non-light emitting area NLA on the encapsulation layer TFE. The bank pattern BP may define a first opening OP1 overlapping the first light emitting area LA1, a second opening OP2 overlapping the second light emitting area LA2, and a third opening OP3 overlapping the third light emitting area LA3.

The reflective pattern RP may be disposed on the bank pattern BP. The reflective pattern RP may cover an upper surface and a side surface of the bank pattern BP. The reflective pattern RP may entirely cover the bank pattern BP in a plan view. The reflective pattern RP may include a material having a relatively high reflectivity, and may reflect light incident on the reflective pattern RP.

The liquid-repellent pattern LRP may be disposed on the reflective pattern RP. In an embodiment, the liquid-repellent pattern LRP may fill the second opening OP2 and the third opening OP3. In addition, the liquid-repellent pattern LRP may cover the upper surface and the side surface of the bank pattern BP. The liquid-repellent pattern LRP may entirely cover the bank pattern BP in a plan view. A portion of the liquid-repellent pattern LRP may be disposed in the first opening OP1. That is, the liquid-repellent pattern LRP may overlap the first, second, and third light emitting areas LA1, LA2, and LA3 and the non-light emitting area NLA.

The liquid-repellent pattern LRP may include a transparent material, and may transmit light incident on the liquid-repellent pattern LRP. In an embodiment, the liquid-repellent pattern LRP may include a liquid-repellent material and a scatterer. The liquid-repellent material may have a liquid-repellent property with respect to a material included in the color conversion pattern CCP, and the scatterer may scatter light incident on the liquid-repellent pattern LRP.

The color conversion pattern CCP may be disposed in the first opening OP1. In an embodiment, the color conversion pattern CCP may convert the incident light L1 into the first transmitted light L2R and emit the first transmitted light L2R. As the liquid-repellent pattern LRP covers the bank pattern BP, the color conversion pattern CCP may be in contact with the liquid-repellent pattern LRP in the first opening OP1.

In an embodiment, the second structure 200 may include a second substrate SUB2, a color filter layer CF, a refractive layer RL, and a protective layer PL. The color filter layer CF may include a first color filter CF1, a second color filter CF2, and a third color filter CF3. The color filter layer CF, the refractive layer RL, and the protective layer PL may be sequentially disposed below the second substrate SUB2.

The display device 30 according to an embodiment of the invention may include the liquid-repellent pattern LRP covering the bank pattern BP while filling the second and third openings OP2 and OP3 defined by the bank pattern BP. The liquid-repellent pattern LRP may include a liquid-repellent material and a scatterer, and accordingly, a width of the bank pattern BP may be reduced. In such an embodiment, as an area occupied by the bank pattern BP is reduced, display quality and process efficiency of the display device 30 may be improved, and the display device 30 may be implemented as a high-resolution display device.

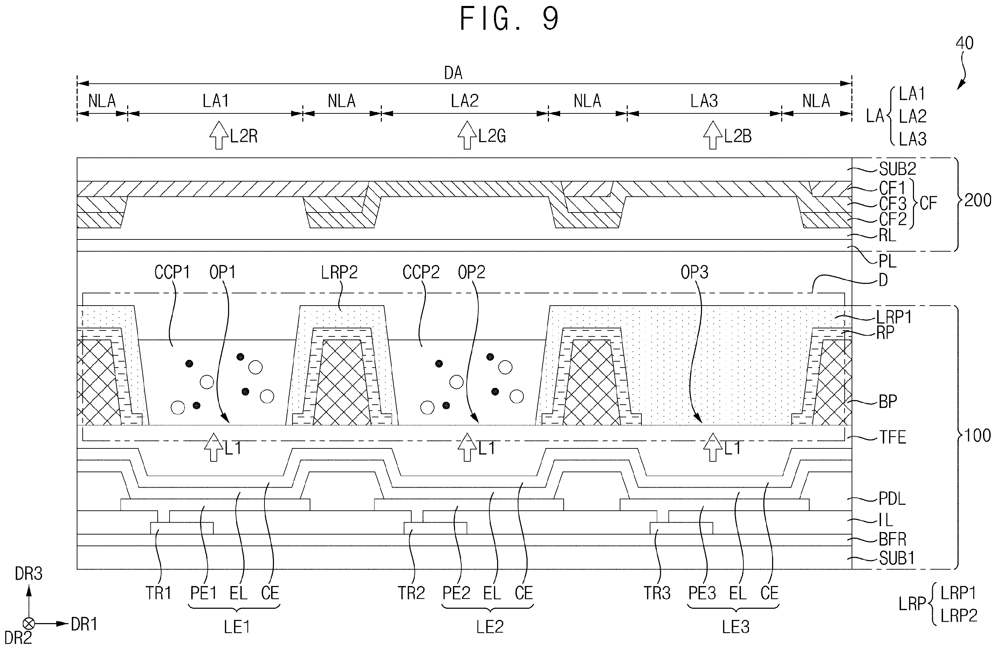

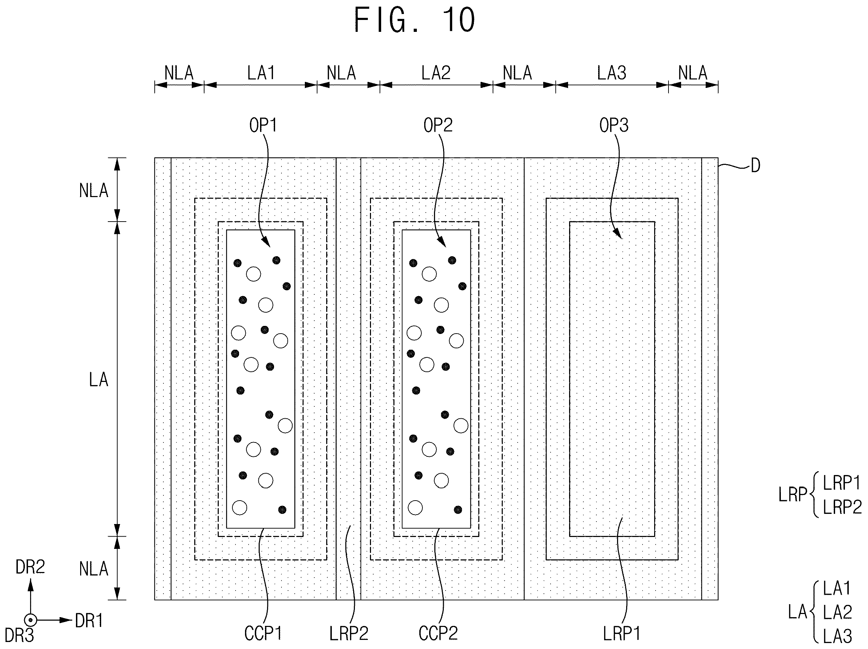

Figure 9 is a cross-sectional view illustrating a display device according to an embodiment of the invention. Figure 10 is an enlarged plan view of area D of Figure 9. Particularly, Figure 9 may correspond to the cross-sectional view of Figure 3, and Figure 10 may correspond to the plan view of Figure 4. That is, Figures 9 and 10 may be views illustrating an example of a display area DA included in a display device 40.

The display device 40 described with reference to Figures 9 and 10 may be substantially the same as or similar to the display device 20 described with reference to Figures 5 and 6 except for a shape of the liquid-repellent pattern LRP. The same or like elements shown in Figures 9 and 10 have been labeled with the same reference characters as used above to describe the embodiments of the display device 10 described with reference to Figures 5 and 6, and any repetitive detailed descriptions will be omitted or simplified.

Referring to Figures 9 and 10, an embodiment of the display device 40 may include the display area DA, and the display area DA may include a first light emitting area LA1, a second light emitting area LA2, a third light emitting area LA3, and a non-light emitting area NLA. The non-light emitting area NLA may be disposed between the first, second, and third light emitting areas LA1, LA2, and LA3 adjacent to each other.

The display device 40 may include a first structure 100 and a second structure 200 which are disposed opposite to each other. The second structure 200 may be spaced apart from the first structure 100 in a third direction DR3. Incident light L1 generated in the first structure 100 may be emitted to the outside (i.e., in the third direction DR3) through the first, second, and third light emitting areas LA1, LA2, and LA3.

The first, second, and third light emitting areas LA1, LA2, and LA3 may emit light in different wavelength bands. In an embodiment, for example, the first light emitting area LA1 may emit a first transmitted light L2R in a red wavelength band, the second light emitting area LA2 may emit a second transmitted light L2G in a green wavelength band, and the third light emitting area LA3 may emit a third transmitted light L2B in a blue wavelength band, but the invention is not limited thereto.

In an embodiment, the first structure 100 may include a first substrate SUB1, a buffer layer BFR, first, second, and third transistors TR1, TR2, and TR3, an insulating layer IL, a pixel defining layer PDL, first, second, and third light emitting elements LE1, LE2, and LE3, an encapsulation layer TFE, a bank pattern BP, a reflective pattern RP, a liquid-repellent pattern LRP, a first color conversion pattern CCP1, and a second color conversion pattern CCP2.

Here, the first light emitting element LE1 may include a first pixel electrode PE1, a light emitting layer EL, and a common electrode CE, the second light emitting element LE2 may include a second pixel electrode PE2, the light emitting layer EL, and the common electrode CE, and the third light emitting element LE3 may include a third pixel electrode PE3, the light emitting layer EL, and the common electrode CE.

The buffer layer BFR, the first, second, and third transistors TR1, TR2, and TR3, the insulating layer IL, the first, second, and third pixel electrodes PE1, PE2, and PE3, the pixel defining layer PDL, the light emitting layer EL, the common electrode CE, and the encapsulation layer TFE may be sequentially disposed on the first substrate SUB1.

The bank pattern BP may be disposed in the non-light emitting area NLA on the encapsulation layer TFE. The bank pattern BP may define a first opening OP1 overlapping the first light emitting area LA1, a second opening OP2 overlapping the second light emitting area LA2, and a third opening OP3 overlapping the third light emitting area LA3.

The reflective pattern RP may be disposed on the bank pattern BP. The reflective pattern RP may cover an upper surface and a side surface of the bank pattern BP. The reflective pattern RP may entirely cover the bank pattern BP in a plan view. The reflective pattern RP may include a material having a relatively high reflectivity, and may reflect light incident on the reflective pattern RP.

The liquid-repellent pattern LRP may be disposed on the reflective pattern RP. In an embodiment, the liquid-repellent pattern LRP may fill the third opening OP3. In addition, the liquid-repellent pattern LRP may cover the upper surface and the side surface of the bank pattern BP. The liquid-repellent pattern LRP may entirely cover the bank pattern BP in a plan view. A portion of the liquid-repellent pattern LRP may be disposed in the first opening OP1 and the second opening OP2.

The liquid-repellent pattern LRP may include a first portion LRP1 disposed in the third opening OP3 and covering the bank pattern BP adjacent to the third opening OP3, and a second portion LRP2 covering the bank pattern BP between the first opening OP1 and the second opening OP2. That is, the liquid-repellent pattern LRP may overlap the first, second, and third light emitting areas LA1, LA2, and LA3 and the non-light emitting area NLA.

The liquid-repellent pattern LRP may include a transparent material, and may transmit light incident on the liquid-repellent pattern LRP. In an embodiment, the liquid-repellent pattern LRP may include a liquid-repellent material and a scatterer. The liquid-repellent material may have a liquid-repellent property with respect to a material included in the first and second color conversion patterns CCP1 and CCP2, and the scatterer may scatter light incident on the liquid-repellent pattern LRP.

The first color conversion pattern CCP1 may be disposed in the first opening OP1, and the second color conversion pattern CCP2 may be disposed in the second opening OP2. In an embodiment, the first color conversion pattern CCP1 may convert the incident light L1 into the first transmitted light L2R and emit the first transmitted light L2R, and the second color conversion pattern CCP2 may convert the incident light L1 into the second transmitted light L2G and emit the second transmitted light L2G. In such an embodiment, the liquid-repellent pattern LRP entirely covers the bank pattern BP in a plan view, such that the first color conversion pattern CCP1 may be in contact with the liquid-repellent pattern LRP in the first opening OP1, and the second color conversion pattern CCP2 may be in contact with the liquid-repellent pattern LRP in the second opening OP2.

In an embodiment, the second structure 200 may include a second substrate SUB2, a color filter layer CF, a refractive layer RL, and a protective layer PL. The color filter layer CF may include a first color filter CF1, a second color filter CF2, and a third color filter CF3. The color filter layer CF, the refractive layer RL, and the protective layer PL may be sequentially disposed below the second substrate SUB2.

The display device 40 according to an embodiment of the invention may include the liquid-repellent pattern LRP covering the bank pattern BP while filling the third opening OP3 defined by the bank pattern BP. The liquid-repellent pattern LRP may include a liquid-repellent material and a scatterer, and accordingly, a width of the bank pattern BP may be reduced. In such an embodiment, as an area occupied by the bank pattern BP is reduced, display quality and process efficiency of the display device 40 may be improved, and the display device 40 may be implemented as a high-resolution display device.

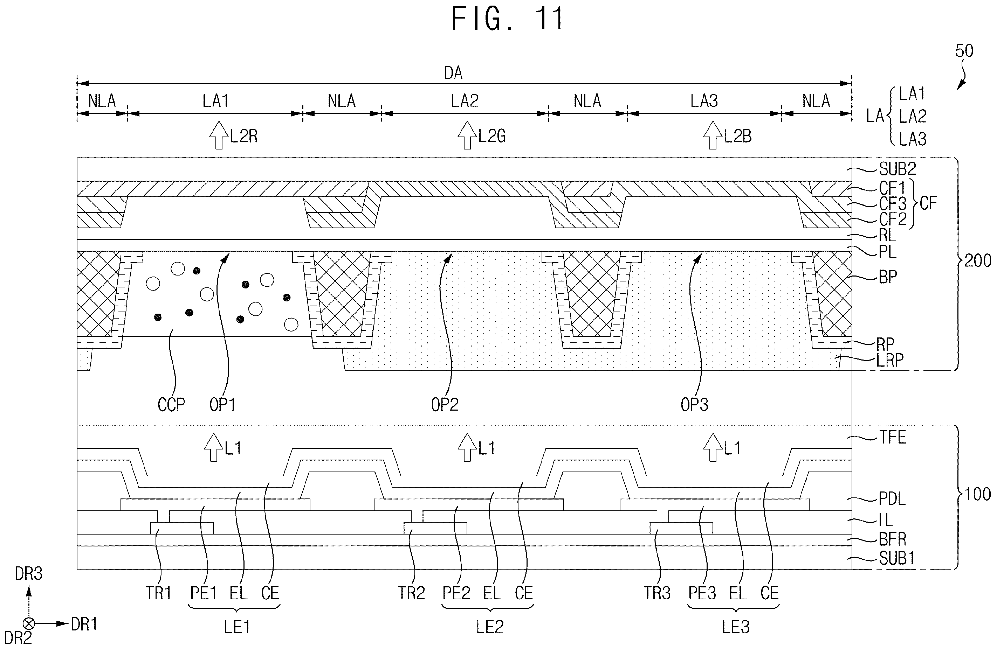

Figure 11 is a cross-sectional view illustrating a display device according to an embodiment of the invention. Particularly, Figure 11 may correspond to the cross-sectional view of Figure 3. That is, Figure 11 may be a cross-sectional view illustrating an example of a display area DA included in a display device 50.

The display device 50 described with reference to Figure 11 may be substantially the same as or similar to the display device 10 described with reference to Figures 1, 2, 3, and 4 except for arrangements of the bank pattern BP, the reflective pattern RP, the liquid-repellent pattern LRP, and the color conversion pattern CCP. The same or like elements shown in Figure 11 have been labeled with the same reference characters as used above to describe the embodiments of the display device 10 described with reference to Figures 1 to 4, and any repetitive detailed descriptions thereof will hereinafter be omitted or simplified.

Referring to Figure 11, an embodiment of the display device 50 may include the display area DA, and the display area DA may include a first light emitting area LA1, a second light emitting area LA2, a third light emitting area LA3, and a non-light emitting area NLA. The non-light emitting area NLA may be disposed between the first, second, and third light emitting areas LA1, LA2, and LA3 adjacent to each other.

The display device 50 may include a first structure 100 and a second structure 200 which are disposed opposite to each other. The second structure 200 may be spaced apart from the first structure 100 in a third direction DR3. Incident light L1 generated in the first structure 100 may be emitted to the outside (i.e., in the third direction DR3) through the first, second, and third light emitting areas LA1, LA2, and LA3.

The first, second, and third light emitting areas LA1, LA2, and LA3 may emit light in different wavelength bands. In an embodiment, for example, the first light emitting area LA1 may emit a first transmitted light L2R in a red wavelength band, the second light emitting area LA2 may emit a second transmitted light L2G in a green wavelength band, and the third light emitting area LA3 may emit a third transmitted light L2B in a blue wavelength band, but the invention is not limited thereto.

In an embodiment, the first structure 100 may include a first substrate SUB1, a buffer layer BFR, first, second, and third transistors TR1, TR2, and TR3, an insulating layer IL, a pixel defining layer PDL, first, second, and third light emitting elements LE1, LE2, and LE3, and an encapsulation layer TFE.

Here, the first light emitting element LE1 may include a first pixel electrode PE1, a light emitting layer EL, and a common electrode CE, the second light emitting element LE2 may include a second pixel electrode PE2, the light emitting layer EL, and the common electrode CE, and the third light emitting element LE3 may include a third pixel electrode PE3, the light emitting layer EL, and the common electrode CE.

The buffer layer BFR, the first, second, and third transistors TR1, TR2, and TR3, the insulating layer IL, the first, second, and third pixel electrodes PE1, PE2, and PE3, the pixel defining layer PDL, the light emitting layer EL, the common electrode CE, and the encapsulation layer TFE may be sequentially disposed on the first substrate SUB1.

In an embodiment, the second structure 200 may include a second substrate SUB2, a color filter layer CF, a refractive layer RL, a protective layer PL, a bank pattern BP, a reflective pattern RP, a liquid-repellent pattern LRP, and a color conversion pattern CCP.

The color filter layer CF may include a first color filter CF1, a second color filter CF2, and a third color filter CF3. The color filter layer CF, the refractive layer RL, and the protective layer PL may be sequentially disposed below the second substrate SUB2.

The bank pattern BP may be disposed in the non-light emitting area NLA below the protective layer PL. The bank pattern BP may define a first opening OP1 overlapping the first light emitting area LA1, a second opening OP2 overlapping the second light emitting area LA2, and a third opening OP3 overlapping the third light emitting area LA3.

The reflective pattern RP may be disposed below the bank pattern BP. The reflective pattern RP may cover a lower surface and a side surface of the bank pattern BP. The reflective pattern RP may entirely cover the bank pattern BP in a plan view. The reflective pattern RP may include a material having a relatively high reflectivity, and may reflect light incident on the reflective pattern RP.

The liquid-repellent pattern LRP may be disposed below the reflective pattern RP. In an embodiment, the liquid-repellent pattern LRP may fill the second opening OP2 and the third opening OP3. In addition, the liquid-repellent pattern LRP may be disposed below at least a portion of the lower surface of the bank pattern BP. The liquid-repellent pattern LRP may overlap the second and third light emitting areas LA2 and LA3 and the non-light emitting area NLA.

The liquid-repellent pattern LRP may include a transparent material, and may transmit light incident on the liquid-repellent pattern LRP. In an embodiment, the liquid-repellent pattern LRP may include a liquid-repellent material and a scatterer. The liquid-repellent material may have a liquid-repellent property with respect to a material included in the color conversion pattern CCP, and the scatterer may scatter light incident on the liquid-repellent pattern LRP.

The color conversion pattern CCP may be disposed in the first opening OP1. In an embodiment, the color conversion pattern CCP may convert the incident light L1 into the first transmitted light L2R and emit the first transmitted light L2R.

Although Figure 11 illustrates an embodiment where a structure corresponding to the structure of the display device 10 described with reference to Figures 1, 2, 3, and 4 is applied to the display device 50, the invention is not limited thereto. In another embodiment, for example, a structure corresponding to the structure of each of the display devices 20, 30, and 40 described with reference to Figures 5, 6, 7, 8, 9, and 10 may also be applied to the display device 50. That is, the bank pattern BP, the reflective pattern RP, the liquid-repellent pattern LRP, the first color conversion pattern CCP1, and the second color conversion pattern CCP2 described with reference to Figures 5 and 6 may be included in the second structure 200, the bank pattern BP, the reflective pattern RP, the liquid-repellent pattern LRP, and the color conversion pattern CCP described with reference to Figures 7 and 8 may be included in the second structure 200, and the bank pattern BP, the reflective pattern RP, the liquid-repellent pattern LRP, the first color conversion pattern CCP1, and the second color conversion pattern CCP2 described with reference to Figures 9 and 10 may be included in the second structure 200.

### [Industrial Applicability]

The present invention can be applied to display devices and electronic devices including the same. For example, the present invention can be applied to high-resolution smartphones, mobile phones, smart pads, smart watches, tablet PCs, vehicle navigation systems, televisions, computer monitors, laptops, and the like.

Although the present invention has been described above with reference to exemplary embodiments, but those of ordinary skill in the art will understand that various modifications and changes can be made to the present invention without departing from the spirit and scope of the present invention as set forth in the claims below.

### [Description of Symbols]

10, 20, 30, 40, 50: display device
LA1, LA2, LA3: first to third light emitting areas
BP: bank pattern
OP1, OP2, OP3: first to third openings
RP: reflective pattern
LRP: liquid-repellent pattern
CCP: color conversion pattern

## Claims

1. A display device comprising:
a substrate, wherein a first light emitting area, a second light emitting area, and a third light emitting area, which emit light in different wavelength bands, respectively, are defined on the substrate;
a bank pattern disposed on the substrate and defining a first opening overlapping the first light emitting area, a second opening overlapping the second light emitting area, and a third opening overlapping the third light emitting area; and
a liquid-repellent pattern filling the second opening and the third opening and disposed on at least a portion of an upper surface of the bank pattern, wherein the liquid-repellent pattern includes a liquid-repellent material.

2. The display device of claim 1, wherein the liquid-repellent pattern further includes a scatterer.

3. The display device of claim 1, further comprising:
a reflective pattern disposed between the bank pattern and the liquid-repellent pattern.

4. The display device of claim 3, wherein the reflective pattern covers the upper surface and a side surface of the bank pattern.

5. The display device of claim 1, further comprising:
a color conversion pattern disposed in the first opening and including a quantum dot.

6. The display device of claim 5, wherein the liquid-repellent pattern covers the upper surface and a side surface of the bank pattern.

7. The display device of claim 6, wherein the color conversion pattern is in contact with a portion of the liquid-repellent pattern in the first opening.

8. The display device of claim 1, further comprising:
a light emitting layer disposed between the substrate and the bank pattern.

9. The display device of claim 1, further comprising:
a color filter layer disposed between the substrate and the bank pattern.

10. The display device of claim 1, wherein
the first light emitting area emits light in a red wavelength band,
the second light emitting area emits light in a green wavelength band, and
the third light emitting area emits light in a blue wavelength band.

11. A display device comprising:
a substrate, wherein a first light emitting area, a second light emitting area, and a third light emitting area, which emit light in different wavelength bands, respectively, are defined on the substrate;
a bank pattern disposed on the substrate and defining a first opening overlapping the first light emitting area, a second opening overlapping the second light emitting area, and a third opening overlapping the third light emitting area; and
a liquid-repellent pattern filling the third opening and disposed on at least a portion of an upper surface of the bank pattern, wherein the liquid-repellent pattern includes a liquid-repellent material.

12. The display device of claim 11, wherein the liquid-repellent pattern further includes a scatterer.

13. The display device of claim 11, further comprising:
a reflective pattern disposed between the bank pattern and the liquid-repellent pattern.

14. The display device of claim 13, wherein the reflective pattern covers the upper surface and a side surface of the bank pattern.

15. The display device of claim 11, wherein the liquid-repellent pattern includes:
a first portion filling the third opening and disposed on at least a portion of the upper surface of the bank pattern adjacent to the third opening; and
a second portion disposed on at least a portion of the upper surface of the bank pattern between the first opening and the second opening.

16. The display device of claim 11, further comprising:
a first color conversion pattern disposed in the first opening and including a first quantum dot; and
a second color conversion pattern disposed in the second opening and including a second quantum dot.

17. The display device of claim 16, wherein the liquid-repellent pattern covers the upper surface and a side surface of the bank pattern.

18. The display device of claim 17, wherein
the first color conversion pattern is in contact with a portion of the liquid-repellent pattern in the first opening, and
the second color conversion pattern is in contact with a portion of the liquid-repellent pattern in the second opening.

19. The display device of claim **11,** further comprising:
a light emitting layer disposed between the substrate and the bank pattern.

20. The display device of claim **11,** further comprising:
a color filter layer disposed between the substrate and the bank pattern.

21. The display device of claim **11,** wherein
the first light emitting area emits light in a red wavelength band,
the second light emitting area emits light in a green wavelength band, and
the third light emitting area emits light in a blue wavelength band.
